Europäisches Patentamt

European Patent Office

Office européen des brevets

(19)

(11) Publication number: **0 064 081**

**B1**

(12) **EUROPEAN PATENT SPECIFICATION**

(45) Date of publication of patent specification: **06.08.86**

(21) Application number: **81903177.4**

(22) Date of filing: **09.11.81**

(86) International application number:
**PCT/US81/01497**

(87) International publication number:
**WO 82/01789 27.05.82 Gazette 82/14**

(51) Int. Cl.⁴: **H 01 L 29/78,** H 01 L 27/14,
H 01 L 31/00

(54) CHARGE COUPLED DEVICE OPEN CIRCUIT IMAGE DETECTOR.

(30) Priority: **10.11.80 US 205544**

(43) Date of publication of application:
**10.11.82 Bulletin 82/45**

(45) Publication of the grant of the patent:
**06.08.86 Bulletin 86/32**

(84) Designated Contracting States:
**DE FR GB**

(56) References cited:
**US-A-3 808 435**
**US-A-3 944 849**
**US-A-4 143 389**
**US-A-4 169 273**
**US-A-4 197 469**

(73) Proprietor: **Santa Barbara Research Center**
**75 Coromar Drive**
**Goleta California 93117 (US)**

(72) Inventor: **PARRISH, William J.**
**2120 Cliff Drive**
**Santa Barbara, CA 93019 (US)**

(74) Representative: **Patentanwälte Kohler -**
**Schwindling - Späth**
**Hohentwielstrasse 41**
**D-7000 Stuttgart 1 (DE)**

Courier Press, Leamington Spa, England.

## Description

The invention relates to a charge transfer device imager comprising: a photosensitive semiconductor diode comprising first and second regions of opposite conductivity types disposed to receive an incident flux of radiation, at least one of said regions being unconnected so that said diode has an open circuit junction voltage proportional to said radiation flux, a capacitive electrode overlying said one unconnected region, a charge transfer device, and connecting means for connecting said charge transfer device to said capacitive electrode.

Such a charge transfer device imager is disclosed in US—A—3 808 435. In this imager, the means for connecting the charge transfer device to the capacitive electrode is comprised of a transfer gate which is controlled either by a clock signal or by the output voltage of said capacitive electrode. In either case, between successive samplings, a reference potential has to be established at the capacitive electrode by means of a further gate or a resistor connected to a reference voltage. Further, for establishing a reference charge between the unconnected region of the photosensitive diode and the capacitive electrode, the known imager requires the incidence of a chopped radiation, either by means of a shutter or of a scanning device. Thus, this charge transfer device imager cannot be used in focal plane array imagers which are neither combined with scanning means nor with shutter means.

In the present invention the connecting means is comprised of a direct injection channel including means for removing a charge packet from the charge transfer device and storing it on said capacitive electrode to begin an integration period, and means for retrieving at least a portion of said charge packet from said capacitive electrode to terminate said integration period and for returning at least said portion to said charge transfer device, wherein the difference between the charge removed from the charge transfer device and the charge returned to the charge transfer device by said removing and returning means is proportional to the change in said radiation flux during said integration period.

A charge transfer device imager according to an embodiment of the invention comprises an open voltage photodiode including a capacitor plate formed monolithically with a P—N junction diode. The capacitor plate, together with one side of the P—N junction, forms a capacitor which is charged by the photocurrent of the diode. The voltage across the capacitor controls the output current of a charge coupled device (CCD) register. The photodetector diode of the present invention operates in an open circuit configuration so that no net current flows across the diode junction as long as the flux of incident radiation is constant. Initially, radiation incident upon the diode does generate a current flow across the diode junction which charges the capacitor to an open circuit voltage proportional to the flux of the incident radiation. However, as soon as the capacitor is charged to the voltage level corresponding to the incident radiation flux, current flow across the diode junction ceases and no current flows unless the radiation flux changes. If the radiation flux changes to a new flux level, current again flows across the diode junction to change the amount of charge stored on the capacitor so that the capacitor is charged (or discharged) to a new voltage level corresponding to the new radiation flux level. As soon as the capacitor voltage attains the new level, current flow across the diode junction again ceases. The direction of current flow depends upon whether the capacitor is to be charged or discharged, corresponding to an increase or a decrease in radiation flux, respectively. Thus, the open circuit voltage of the capacitor modulates as a function of the change in incident radiation flux.

It is an unexpected result of this invention that the nonlinearity inherent in the open circuit voltage response of the diode to incident radiation compensates for the nonlinearity in the output current response of the CCD register. As a result, the output current of the CCD register is a linear function of the incident radiation flux. More specifically, the open circuit photodiode capacitor of this invention controls the current in a CCD register by accepting a charge packet of predetermined size from the CCD register, the charge packet being stored on the photodiode capacitor during an integration period when radiation is incident on the photodiode. At the end of the integration period, a charge packet of different size is returned to the CCD register. The change in the size of the charge packet is proportional to the change in radiation flux during the integration period and therefore is representative of a video signal generated by the photodiode. The advantage of this direct injection device is that it is inherently insensitive to background radiation or radiation having a constant flux.

The invention is best understood by reference to the accompanying drawings of which:

Fig. 1a is a schematic diagram of a charge coupled device imager of the prior art;

Fig. 1b is a simplified perspective view partially in phantom line of a photodiode of the prior art;

Fig. 2 is a cross-sectional view of the presently preferred embodiment open circuit photodiode capacitor of the present invention;

Fig. 3 is a simplified schematic diagram characterizing the operation of the AC coupled direct charge injection device of this invention;

Fig. 4a is a simplified schematic diagram of the preferred embodiment AC coupled direct charge injection device of the invention;

Fig. 4b is a simplified diagram of the electrical semiconductor surface potential $S_2$ corresponding to the diagram of Fig. 4a;

Fig. 5a is an exemplary diagram of the time domain waveform of the photon flux $R_{Image}$ of the image radiation incident upon a photodetector, which is illustrated as a saw tooth waveform for the sake of tutorial example only;

Fig. 5b is an exemplary diagram of the time domain waveform of the photon flux $R_{dc}$ of the background radiation incident upon a photodetector, which is illustrated as a step function for the sake of tutorial example only;

Fig. 6a is a diagram of the time domain waveform of the clock signal $\phi'_{ccd}$ applied to the device of Fig. 4a;

Fig. 6b is a diagram of the time domain waveform of the clock signal $\phi'_{tr}$;

Fig. 6c is a diagram of the time domain waveform of the clock signal $\phi'_{store}$;

Fig. 6d is a diagram of the time domain waveform of the total radiation flux $R_{image} + R_{dc}$ from Figs. 5a and 5b respectively incident upon the photodetector of Fig. 4a;

Fig. 6e is a diagram of the time domain waveform of the charge $Q_i$ stored in the device of Fig. 4a corresponding to Fig. 6d;

Fig. 7a is a diagram of the time domain waveform of the radiation flux $R_{image} + R_{dc}$ corresponding to Fig. 6d;

Fig. 7b is a diagram of the time domain waveform of the stored charge $Q_i$; and

Fig. 7c is a diagram of the time domain waveform of the charge $Q_{ccd}$ injected into the CCD register of Fig. 4a.

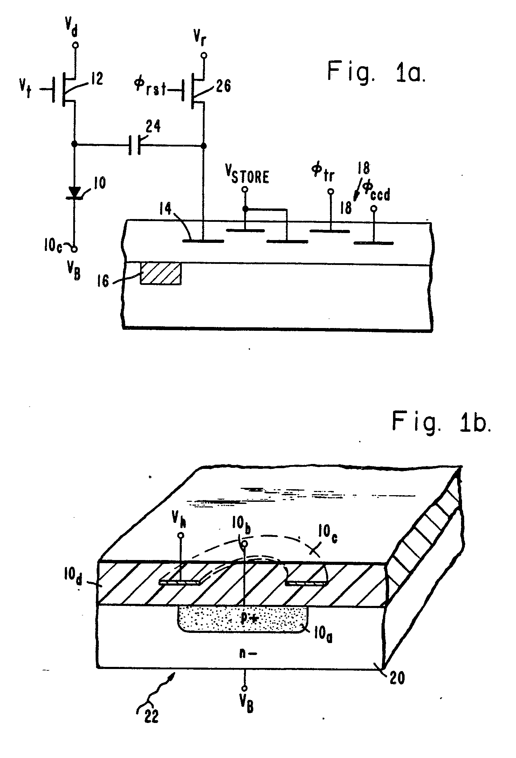

Referring to the schematic diagram of Fig. 1a, prior art infrared imagers typically include a photosensitive diode 10 which generates a photocurrent creating a voltage drop across a resistive load device such as a metal oxide semiconductor field effect transistor (MOSFET) 12, the voltage drop determining the voltage on a control gate 14 which regulates the injection of charge from an input diffusion 16 into a CCD register 18. Control of charge injection into a CCD in this manner is known as CCD gate modulation and is fully described in Sequin et al, *Charge Transfer Devices*, Academic Press, New York (1975), pps. 48—52, the disclosure which is hereby incorporated by reference. Fig. 1b is a simplified perspective view of the prior art photodiode 10 which includes a diffusion 10a of P-type conductivity in the top surface of a semiconductive layer 20 of N-type conductivity, an electrical contact 10b to the P-type diffusion 10a and a bias electrode 10c insulated by a dielectric layer 10d.

One problem with the device of Fig. 1 is that the nonlinear response of the output current $I_{ccd}$ of the CCD register 18 as a function of the voltage $V_g$ applied to its control gate 14 distorts the output video signal.

Another problem with the prior art device of Fig. 1a is that an external coupling capacitor 24 must be interposed between the photodiode output 10b and the CCD control gate 14 in order to filter out the constant DC output generated by background radiation in order to prevent saturation of the detector by excessive background radiation or a reduction in dynamic range of the detector. Typically, the radiation 22 incident on the photodiode 10 includes both an image from which a video signal is to be generated and background radiation which contains no information. It is desirable to create a video signal from an image in the presence of either a light or a dark background, which can only be accomplished within the limited dynamic range of the CCD register 18 by filtering out background radiation from the video signal. The background radiation typically has a constant flux which generates a constant or a DC component in the output photocurrent of the photodiode 10. In order to render the voltage on the CCD input gate 14 independent of the DC component of the diode output current, the potential on one plate of the external capacitor 24 is reset to a voltage $V_r$ at the end of each CCD clock period under the control of a reset switch 26 gated by a clock signal $\phi_{rst}$. A significant disadvantage of this arrangement is that the capacitor 24 takes up a significant amount of space, thus reducing the device density on the semiconductor layer 20.

Another problem of the device of Fig. 1b is that surface defects between the substrate 20 and the overlying insulating layer 10d may permit carrier leakage across the photodiode junction formed between the diode diffusion 10a and the semiconductor layer 20, uncontrollably changing the electrical characteristics of the diode 10. In order to avoid this problem, the bias electrode 10c overlies the junction between the diode diffusion 10a and the semiconductor layer 20 and has an applied voltage $V_h$ which depletes surface charge carriers from the region of the diode junction to prevent leakage across the junction.

In summary, the load MOSFET 12, the coupling capacitor 24 and the bias electrode 10c take up significant amounts of space on the underlying semiconductor layer, thus limiting the density of the device.

It has been a desirable goal in the art to provide an imager in which the necessity for a resistive load device such as the MOSFET 12, for the external coupling capacitor 24 and for the bias gate 10c is eliminated and in which the nonlinearity of the output current $I_{ccd}$ as a function of the input gate voltage $V_g$ of the CCD register 18 is fully compensated to provide a linear output current as a function of incident radiation flux.

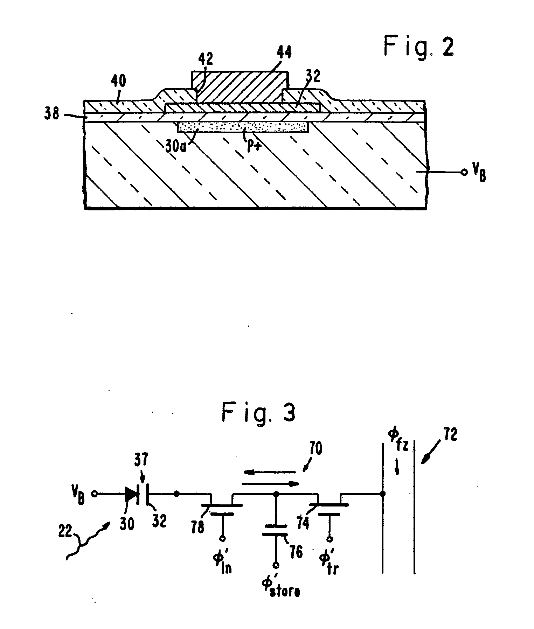

As illustrated in Fig. 2 the invention makes use of an open circuit photodiode 30 comprising a semiconductive layer 20 of N-type conductivity, a diode diffusion 30a of P-type conductivity in the semiconductor layer 20 and an insulated capacitor plate 32 overlying the semiconductor layer 20 in registration with the diode diffusion 30a so as to form a photodiode capacitor 37. The diode diffusion 30a is not electrically connected so that the didoe 30 is in an open circuit configuration. Radiation 22 incident upon the diode 30 generates current flow across diode junction 36 between the the diffusion 30a and the remainder of the semiconductor layer 20. The current flow across the junction 36 charges the junction 36 and the capacitor 37 to an open circuit voltage which is proportional to the incident radiation flux. As soon as the capacitor 37 is so charged, current flow across the diode junction 36 ceases until the radiation flux again changes. If the radiation flux later changes to a new level, then the open circuit diode junction voltage changes to that current again flows across the junction 36 to charge (or discharge) the capacitor 37 to a new voltage corresponding to the new radiation flux level. As soon as the new capacitor voltage level is attained, current flow across the junction 36 again ceases. The direction of current flow across the junction 36 depends upon whether the charge on the capacitor 37 is increased or decreased, corresponding to an increase or decrease in radiation flux, respectively.

In the preferred embodiment illustrated in Fig. 2, the open circuit photodiode 30 is formed on a semiconductive substrate or layer 20 of N-type conductivity, and the P-type diode region 30a may be formed by ion implantation or diffusion. A dielectric layer 38 such as silicon dioxide is placed over the top surface of the substrate 20 and an aluminum-nickel capacitor plate 32 is placed over the dielectric layer in registration with the diode region 30a. A glass layer 40 is placed over the capacitor plate 32 and over exposed portions of the dielectric layer 38, the glass layer 40 having a contact opening 42 to the capacitor plate 32 in which an indium bump 44 is deposited as an electrode contact to the capacitor plate 32. A bias voltage $V_b$ is applied to the substrate 20 of Fig. 2 and is preferably selected so as to impose an electrical field which is equal and opposite to the electrical field created by surface charge $Q_{ss}$ at the surface of the substrate 20.

The structure of the open circuit diode capacitor 37 described above is used in a novel open circuit direct injection device useful in charge coupled device imagers. This device is illustrated for the sake of simplified explanation as a bucket brigade device in Fig. 3 and includes an intervening bucket brigade direct injection channel 70 interposed between the open circuit photodiode capacitor 37 and a charge coupled device serial output register 72. The direct injection channel 70 includes a first transfer MOSFET 74, a MOS store capacitor 76 and an input MOSFET 78 connected to the capacitor plate 32 of the open circuit photodiode capacitor 37. Unlike the gate modulation technique utilized in prior art the direct injection device of Fig. 3 actually injects the charge stored on the open circuit photodiode capacitor 37 directly into the output CCD register 72. Specifically, a charge packet of a predetermined size $Q_{fz}$ is diverted from the CCD register 72 and stored on the capacitor plate 32 during an integration period. The charge packet is then retrieved from the open circuit photodiode capacitor plate 32 and reinjected into the CCD register 72. However, the size of the charge packet is "altered" during the integration period if the radiation flux incident upon the open circuit photodiode 30 has changed. The change in the size of the charge packet represents the video signal of the image viewed by the photodiode 30.

Operation of the open circuit direct injection device of Fig. 3 begins when a charge packet of predetermined size, preferably of a size equal to the fat zero level $Q_{fz}$ of the CCD register 72, is transferred serially in the CCD register 72. When this charge packet is adjacent the transfer MOSFET 74, a clock signal $\phi'_{tr}$ turns on to apply an attractive voltage to the gate of the MOSFET 74 while a clock signal $\phi'_{store}$ turns on to apply an attractive voltage to the plate of the MOS capacitor 76 so that the charge packet is transferred out of the CCD register 72 beneath the gate 74a of the transfer MOSFET 74 and stored on the store capacitor 76. Subsequently, the clock signals $\phi'_{tr}$ and $\phi'_{store}$ turn off while the clock signal $\phi'_{in}$ applied to the gate of the input MOSFET 78 is on so that the charge packet is withdrawn from the capacitor 76 and flows through the input MOSFET 78 to be stored on the detector capacitor plate 32, after which the clock signal $\phi'_{in}$ turns off. During the subsequent integration period, if the flux R of radiation 22 incident on the open circuit photodiode 30 changes by an amount $\Delta R$, the open circuit voltage $V_{oc}$ on the capacitor plate 32 changes by a proportional amount $\Delta V_{oc}$, in accordance with the discussion given above in connection with Fig. 3. At the end of the integration period, the clock signals $\phi'_{in}$ and $\phi'_{store}$ turn on so that the charge packet is retrieved from the capacitor plate 32 to again be stored on the MOS capacitor 76, after which the clock signal $\phi'_{in}$ turns off. Because the open circuit voltage on the capacitor plate 32 has changed, the amount of charge released from the capacitor plate 32 to the store capacitor 76 is not equal to the original size $Q_{fz}$ of the charge packet previously withdrawn from the CCD register 72. It may be shown that the change $\Delta Q$ in the size of the charge packet from its original fat zero level $Q_{fz}$ is equal to the capacitance $C_{det}$ of the detector capacitor 37 multiplied by the change $\Delta V_{oc}$ in the open circuit voltage $V_{oc}$ of the photodiode 30, which may be expressed as follows:

$$\Delta Q = \Delta V_{oc} \times C_{det}.$$

It should be noted that $\Delta Q$ may be positive or negative, depending upon whether the radiation flux increased or decreased during the integration period.

The size $Q$ of the charge packet stored on the store capacitor 76 at the end of the integration period is equal to the fat zero level $Q_{fz}$ of the CCD register 72 plus $\Delta Q$ which may be expressed as follows:

$$Q = Q_{fz} + \Delta Q$$

Subsequently, the charge packet stored on the store capacitor 76 is reinjected into the CCD register 72 when the clock signal $\phi'_{store}$ turns off while the clock signal $\phi'_{tr}$ turns on so that the charge packet is withdrawn from the store capacitor 76 and passes beneath the transfer gate 74a and into the CCD register 72. Thus, a serial train of charge packets may be generated in the output register 72 forming a video signal represented by the difference $\Delta Q$ between the size of each charge packet and fat zero level $Q_{fz}$.

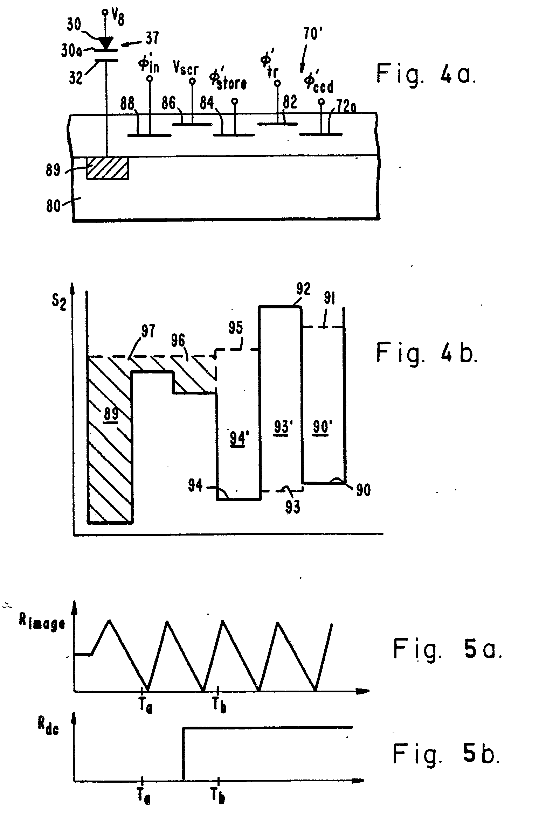

The preferred embodiment of the invention is illustrated in Fig. 4a in which the open circuit photodiode capacitor 37 controls the direct injection of charge packets transferred serially in the CCD output register 72 by means of an intervening CCD channel 70' formed with the output CCD register 72 on an N-type semiconductive layer 80 including a CCD electrode 72a connected to receive the clock signal $\phi'_{ccd}$. The intervening CCD channel 70' includes a transfer gate 82 connected to receive the clock signal $\phi'_{tr}$, a store gate 84 connected to receive the clock signal $\phi'_{store}$, a screen gate 86 connected to a voltage source $V_{scr}$ and an input gate 88 connected to recieve the clock signal $\phi'_{in}$. A P-type diffusion 89 adjacent the input gate 88 is connected to the capacitor plate 32 to permit charge transfer between the capacitor plate 32 and the intermediate CCD channel 70'. It will be easily recognized by those skilled in the art that the intervening CCD channel 70' of Fig. 4a is equivalent to the bucket brigade device 70 of Fig. 3.

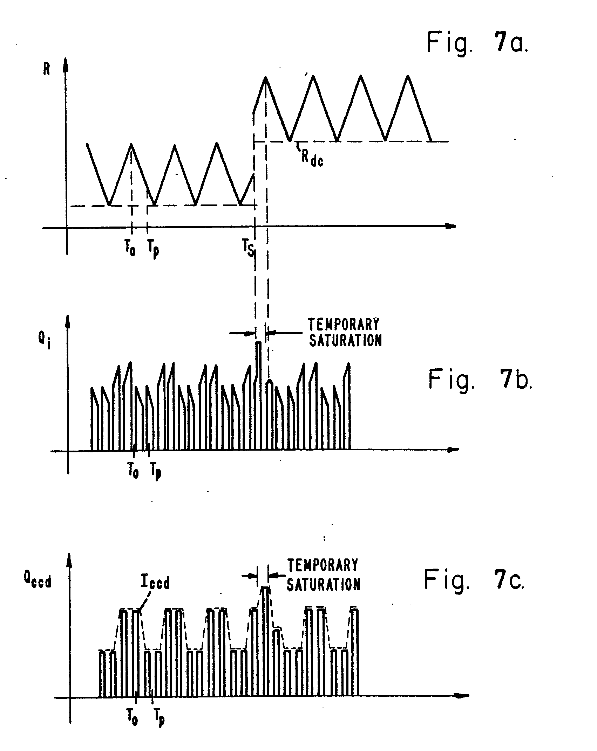

Operation of the charge coupled direct injection device of Fig. 4a will now be described in detail by simultaneous reference to Figs. 4a, 4b, 5a, 5b, 6a—6e and 7a—7c. Figs. 6a through 6e are plotted on a time scale expanded from that of Fig. 7a and correspond to the time window between $T_0$ and $T_p$ of Fig. 7a. For the sake of simplified explanation only, in this description it will be assumed that the total incident radiation flux follows the waveform illustrated in Fig. 7a, in which the sawtooth waveform of the image radiation flux $R_{image}$ illustrated in Fig. 5a is superimposed upon the step function waveform of the background radiation flux $R_{dc}$ illustrated in Fig. 5b. It will be seen that the effects of the background radiation flux $R_{dc}$ are virtually eliminated in the CCD output current $I_{ccd}$ in the device of Fig. 4a.

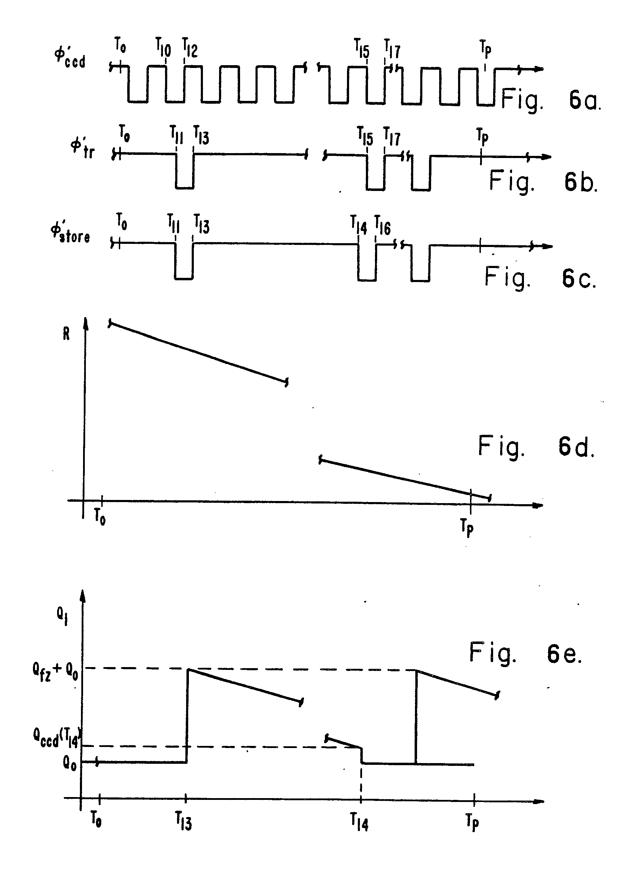

Referring to Fig. 6a, operation begins at time $T_{10}$ when the clock signal $\phi'_{ccd}$ turns on, causing the surface potential $S_2$ of the substrate 80 illustrated in Fig. 4b to fall from the barrier level 91 underlying the CCD electrode 72a to the well level 90, which permits a fat zero charge packet $Q_{fz}$ to be transferred and held beneath the CCD electrode 72a. At time $T_{11}$, the clock signals $\phi'_{tr}$ and $\phi'_{store}$ illustrated in Figs. 6b and 6c respectively, turn on, causing the surface potential $S_2$ to decrease from the barrier levels 92 and 95 underlying the transfer gate 82 and the store gate 84 respectively, to the well levels 93 and 94 respectively. Subsequently, at $T_{12}$ to the clock signal $\phi'_{ccd}$ turns off, transferring the fat zero charge packet $Q_{fz}$ into the potential wells 93' and 94'. Subsequently, at time $T_{13}$ the clock signals $\phi'_{tr}$ and $\phi'_{store}$ turn off, causing the surface

potential $S_2$ to return to the barrier levels 92 and 95 so that the fat zero charge packet $Q_{fz}$ is transferred into a region including the diffusion 89 and potential wells 96 and 97 underlying the electrodes 86 and 88 respectively. Therefore, as soon as the clock signals $\phi'_{tr}$ and $\phi'_{store}$ turn off at time $T_{13}$, the amount of charge $Q_i$ stored in the region 89, 96, 97 immediately increases from an initial level $Q_0$ to a new level $Q_{fz}+Q_0$ as illustrated in Fig. 6e. The decreasing radiation flux R illustrated in Fig. 6d causes the open circuit voltage $V_{oc}$ of the photodiode 30 to decrease, reducing the positive charge stored in the P-type diffusion 30a of the open circuit photodiode 30, causing a corresponding decrease in the negative charge (electrons) stored on the capacitor plate 32. The negative charge (electrons) leaving the capacitor plate 32 flows to the CCD diffusion 89 and combines with holes in the CCD diffusion 89, causing a corresponding decrease in the amount of positive charge $Q_i$ stored in the region 89, 96, 97. Accordingly, Fig. 6e illustrates that, beginning at time $T_{13}$, the stored charge $Q_i$ decreases in proportion to the decrease in radiation flux R illustrated in Fig. 6d. At time $T_{14}$ the stored charge $Q_i$ is removed from the region 89, 96, 97 when the clock signal $\phi'_{store}$ turns on to decrease the surface potential $S_2$ from the barrier level 95 to the well level 94 so that the stored charge $Q_i$ is withdrawn from the region 89, 96, 97 and held beneath the store gate 84. Subsequently, at time $T_{15}$ the clock signals $\phi'_{ccd}$ and $\phi'_{tr}$ turn on to decrease the surface potential $S_2$ from the barrier levels 92, 91 respectively to the potential well levels 93, 90 respectively. Thereafter at time $T_{16}$ the clock signal $\phi'_{store}$ turns off, causing the surface potential $S_2$ to increase from the potential well level 94 to the barrier level 95 while at time $T_{17}$ the clock signal $\phi_{tr}$ is turned off to cause the surface potential $S_2$ to increase from the potential well level 93 to the barrier level 92, thus causing the stored charge $Q_i$ to be injected into the potential well 90' beneath the CCD gate 72a. The amount of charge $Q_{ccd}$ injected into the CCD output register 72 at time $T_{17}$ is indicated in dashed line in Fig. 10e and is equal to the charge $Q_i$ previously stored in the region 89, 96, 97 at time $T_{14}$.

Comparing Figs. 6e and 6d, it is apparent that the stored charge $Q_i$ follows the radiation flux R of Fig. 6d but is periodically reset in synchronism with the clock signal $\phi'_{store}$ to an initial level $Q_0$. This is best illustrated in Fig. 11b which clearly shows that the store charge $Q_i$ increases during those periods corresponding to the positive slope of the radiation flux sawtooth waveform of Fig. 7a and decreases during those periods corresponding to the negative slope of the sawtooth waveform of Fig. 7a. The output charge $Q_{ccd}$ injected into the CCD register 72 at the end of each integration period is illustrated in Fig. 7c corresponding to the time scale of Figs. 7a and 7b, clearly showing that the output charge $Q_{ccd}$ injected at the end of each integration period into the output register 72 is precisely equal to the

stored charge $Q_i$ at the end of each integration period. The waveform of the CCD output current $I_{ccd}$ is approximated in Fig. 7c by the dashed line following the peak values of the output charge $Q_{ccd}$ of Fig. 7c. The dashed line of Fig. 7c clearly shows that the output current $I_{ccd}$ roughly follows the sawtooth waveform of Fig. 7a of the image radiation flux $R_{image}$. The effect of the background radiation flux step function waveform $R_{dc}$ is virtually removed from the waveform of the output current $I_{ccd}$ with a minor exception that the device is temporarily saturated at time $T_s$ of Figs. 7a—c when the background radiation flux $R_{dc}$ suddenly increases in accordance with its step function waveform as illustrated in Fig. 7a. The temporary saturation of the output device is limited to the single integration period beginning at time $T_s$, and Fig. 7c clearly shows that the output current $I_{ccd}$ resumes its usually nearly sawtooth waveform shortly after time $T_s$. As a result, the output current $I_{ccd}$ is a reliable representation of the image radiation flux $R_{image}$ and is virtually independent of the background radiation flux $R_{dc}$. Truncation of the sawtooth waveform in Fig. 7c occurs in this tutorial example only because the center frequency of the input signal $R_{image}$ of Fig. 7a is close to the sampling frequency defined by the clock signal $\phi'_{store}$ of Fig. 7c. It should be understood that a skilled worker may select a sufficiently high frequency for each clock signal illustrated in Figs. 7a, 7b and 7c so that the sampling frequency of the device of Fig. 4a is significantly greater than the frequency of the image viewed by the device.

An output video signal may be derived from a plurality of intervening CCD channels 70' and open circuit photodiode capacitors 37 in a planar array (not shown) comprising a plurality of such photodiode capacitors. A significant advantage of the open circuit direct injection device of Figs. 3 and 4a is that the video signal (represented by the charge difference $\Delta Q$) is virtually insensitive to background radiation having a constant flux.

## Claims

1. A charge transfer device imager comprising:
a photosensitive semiconductor diode (30) comprising first and second regions of opposite conductivity types disposed to receive an incident flux of radiation (22), at least one of said regions being unconnected so that said diode (30) has an open circuit junction voltage proportional to said radiation flux,
a capacitive electrode (32) overlying said one unconnected region,
a charge transfer device (72), and
connecting means (70) for connecting said charge transfer device (72) to said capacitive electrode (32),
characterized in that
said connecting means is comprised of a direct injection channel (70) including
means for removing a charge packet from the charge transfer device (72) and storing it on said capacitive electrode (32) to begin an integration period, and
means for retrieving at least one portion of said charge packet from said capacitive electrode (32) to terminate said integration period and for returning at least said portion to said charge transfer device (72),
wherein the difference between the charge removed from the charge transfer device and the charge returned to the charge transfer device by said removing and returning means is proportional to the change in said radiation flux during said integration period.

2. The imager of claim 1, wherein said direct injection channel (70') comprises a diffused region (89) and a conductor is connected between said diffused region (89) and said capacitive electrode (32).

## Patentansprüche

1. Von einer ladungsgekoppelten Anordnung gebildeter Bilddetektor mit

— einer photoempfindlichen Halbleiterdiode (30), die zwei Regionen entgegengesetzten Leitfähigkeitstyps aufweist, die so angeordnet sind, daß sie einem einfallenden Strahlungsfluß (22) ausgesetzt sind, und von denen wenigstens eine ohne Anschluß ist, do saß die Diode (30) eine Leerlauf-Übergangsspannung hat, die dem Strahlungsfluß proportional ist,
— einer die nicht angeschlossene Region überdeckenden kapazitiven Elektrode (32),
— einer ladungsgekoppelten Anordnung (72) und
— Verbindungsmitteln (70) zur Verbindung der ladungsgekoppelten Anordnung (72) und der kapazitiven Elektrode (32)),

dadurch gekennzeichnet, daß

— die Verbindungsmittel von einem Direktinjektions-Kanal (70) gebildet werden, der
— Mittel zum Entnehmen eines Ladungspaketes aus der ladungsgekoppelten Anordnung (72) und zum Speichern dieses Ladungspaketes auf der kapazitiven Elektrode (32) zu Beginn einer Integrationszeit und
— Mittel zum Wiedergewinner wenigstens eines Teiles des Ladungspaketes von der genannten kapazitiven Elektrode (32) zur Beendigung der Integrationszeit und zum Zurückgeben wenigstens dieses Teiles des Ladungspaketes an die ladungsgekoppelte Anordnung (72) aufweist,
— wobei der Unterschied zwischen der der ladungsgekoppelten Anordnung entnommenen und der an die ladungsgekoppelte Anordnung zurückgegebenen Ladungsmenge zur Änderung des Strahlungsflusses während der Integrationszeit proportional ist.

2. Bilddetektor nach Anspruch 1, bei dem der Direktinjektions-Kanal (70') eine Diffusionszone (89) aufweist und die Diffusionszone (89) und die genannte kapazitive Elektrode (32) durch einen Leiter miteinander verbunden sind.

## Revendications

1. Un imageur à dispositif de transfert de charge comprenant:

une diode à semiconducteur photosensible (30) comprenant des première et seconde régions ayant des types de conductivité opposés, qui sont disposées de façon à recevoir un flux de rayonnement incident (22), l'une au moins de ces régions n'étant pas connectée, de façon que la diode (30) ait une tension de jonction en circuit ouvert proportionnelle au flux de rayonnement,

une électeode capacitive (32) recouvrant la région non connectée,

un dispositif de transfert de charge (72), et

des moyens de connexion (70) destinés à connecter le dispositif de transfert de charge (72) à l'électrode capacitive (32),

caractérisé en ce que:

les moyens de connexion sont constitués par un canal d'injection directe (70) comprenant des moyens destinés à extraire un paquet de charge du dispositif de transfert de charge (72) et à le stocker sur l'électrode capacitive (32) pour commencer une période d'intégration, et

des moyens destinés à récupérer au moins une partie de ce paquet de charge sur l'électrode capacitive (32) pour mettre fin à la période d'intégration et pour ramener cette partie, au moins, au dispositif de transfert de charge (72),

et la différence entre la charge extraite du dispositif de transfert de charge et la charge ramenée au dispositif de transfert de charge par les moyens d'extraction et de retour est proportionnelle au changement du flux de rayonnement pendant la période d'intégration.

2. L'imageur de la revendication 1, dans lequel le canal d'injection directe (70') comprend une région diffusée (89), et un conducteur est connecté entre cette région diffusée (89) et l'électrode capacitive (32).

Fig. 1a.

Fig. 1b.

Fig. 2

Fig. 3

Fig. 4a.

Fig. 4b.

Fig. 5a.

Fig. 5b.

Fig. 6a.

Fig. 6b.

Fig. 6c.

Fig. 6d.

Fig. 6e.

Fig. 7a.

TEMPORARY
SATURATION

Fig. 7b.

TEMPORARY
SATURATION

Fig. 7c.